# EUROPEAN PATENT APPLICATION

(11) **EP 1 335 016 A1**
(43) Date of publication of application: **13.08.2003**
(21) Application number: 03250591.9
(22) Date of filing: 30.01.2003
(51) Int. Cl.: C11D 11/00, H01L 21/306, C11D 7/26, C11D 7/34, C11D 7/32

(54) **Cleaning composition**

(30) Priority: 06.02.2002 US 354839 P
(71) Applicant: Shipley Company LLC, Marlborough, MA 01752 (US)
(72) Inventor: Anzures, Edgardo, Westborough, Massachusetts 01581 (US); Barr, Robert K., Shrewsbury, Massachusetts 01545 (US); Lundy, Daniel E., Winchendon, Massachusetts 01475 (US); O'Connor, Corey, Worcester, Massachusetts 01604 (US)
(74) Representative: Kent, Venetia Katherine

(57) **Abstract**

A cleaning composition composed of a non-chelating organic acid, salt or ester thereof, and a chelating organic acid, salt or ester thereof that may be used to clean residue and scum from a substrate. The cleaning composition is suitable for cleaning residue and scum derived from photoresist.

## Description

### Background of the Invention

The present invention is directed to a cleaning composition and method for cleaning built-up organic residues from a substrate. More specifically, the present invention is directed to an acid cleaning composition and method for cleaning built-up organic residues deposited from photoresist from a substrate.

Organic contaminants, such as built-up residue and scum from photoresist, present difficult cleaning problems for the electronics industry where organic residue and scum build-up on various products and apparatus during manufacturing. Photoresist materials are employed in the manufacturing of semiconductor devices, and electronic components such as integrated circuits, photomasks for manufacturing integrated circuits, printed wiring boards and the like as well as planographic printing plates. In photolithographic processing, a step in the process of making electronic devices and components, a substrate surface is coated with a photoresist, i.e., a coating composition that is sensitive to actinic radiation, e.g., ultraviolet light, X-rays, electron beams and the like, to give a layer that is sensitive to actinic radiation which is irradiated pattern-wise with the actinic radiation. The irradiated photoresist is then developed with a developer solution to form a patterned photoresist layer that serves to selectively protect the substrate surface from etching, plating or diffusion of dopants.

Photoresists may be positive-working, or negative-working. Such photoresists may be liquid, or dry film. A photoresist composition of the positive-working type has such a photosensitivity that solubility of the composition in the developer solution is increased by exposure to light so that the patterned photoresist layer is formed on the areas unexposed to ultraviolet light where the composition is left undissolved. A negative-working photoresist composition exhibits behavior of a sensitivity and solubility that is the reverse of the positive-working photoresist.

Along with recent progress in the technology of semiconductor devices with a requirement for finer and finer high-fidelity patterning of a line width of 1 micron or even finer to comply with the trend of increased density of integration in semiconductor devices, photolithographic processes of patterning using a positive-working photoresist also envisages a difficult problem. When patterning is desired of an extremely fine contact hole in a fine pattern, alkaline developer solution is admixed with a surface active agent with an object to increase the wettability of the substrate surface with the aqueous developer solution. One of the problems in the addition of a surface active agent to the developer solution is that film residues and scums sometimes occur on the exposed areas where the photoresist layer should be dissolved away as completely and cleanly as possible. Although the film residues and scums can be removed by gently treating the surface with oxygen plasma or sputtering, no complete solution of the problem can be obtained by such methods because such treatments must be performed under well controlled troublesome conditions and is not efficient in respect of smooth removal of the scums, or gives no uniform effect of treatment in finely patterned areas having contact holes of about 1 micron or smaller in diameter.

U.S. 4,820,621 to Tanaka et al. has addressed the problem of residue and scum formation by modifying a developer solution with the addition of a non-ionic surface active agent that is a polyoxyethylene alkyl-substituted phenyl ether. The ether is included in the developer solution in an amount of from 50 to 5000 ppm (parts per million). The developer solution is employed in patterning using a positive-working photoresist composition composed of an alkali-soluble novolac resin and a naphthoquinone diazide compound. The '621 patent alleges that patterning the positive photoresist with the developer containing the polyoxyethylene alkyl-substituted phenyl ether prevents formation of residues and scums after development.

Similar residue and scum formation also occur when negative-working photoresists are employed. For example, in manufacturing printed circuit boards UV curable negative-working photoresists may be used. Exposed portions of the photoresist become insoluble in alkaline developer solution and form a protective barrier to other processing chemicals such as etching and plating solutions. Unexposed portions of the photoresist are to rinse freely from the circuit board with an alkaline solution such as a 1% sodium carbonate, monohydrate in water. Development occurs because polymers in the photoresist contain acid functionality. Such acid functionality within the polymers are neutralized in alkaline solution forming a water soluble organic salt. As the dissolved photoresist builds up in solution (developer loading), insoluble organic materials begin to form in the developing tank eventually forming a water insoluble residue or scum. Presence of anti-foam additives (conventionally added to developing solutions to minimize foaming) greatly increases the tendency for residue and scum to form. As the level of scum builds, chances increase for an inadvertent redeposit of these water insoluble residues onto the developed circuit board. Such redeposited residues cause a retardation of the etching solution (etching chemistries have difficulty penetrating any organic residues). Where etch is retarded, circuit shorts form causing a defective circuit board. In addition to increasing the potential for defective circuit boards, the residue also makes cleaning equipment difficult, thus increasing maintenance time.

In addition to the problem of built-up residue and scum formation from primary photoresists, there also is a residue and scum build-up problem from secondary photoresists. Such secondary photoresists may be employed in soldermasks. Residue and scum are deposited on a substrate as a result of component separation in the soldermask. Such component separation may be exacerbated when an improperly balanced soldermask developer solution, i.e., improper developing conditions and/or soldermask developer solution chemistry, contact the soldermask. Built-up residue and scum from secondary photoresists may appear as a bright green coating on a substrate such as a developer apparatus.

U.S. 5,922,522 to Barr et al.; U.S. 6,063,550 to Lundy et al.; and U.S. 6,248,506 B1 to Lundy et al. disclose surfactant and surfactant mixtures included a developer solutions that prevent or inhibit the formation of residues and scum on circuit boards and circuit board manufacturing equipment. Such surfactants are composed of a hydrophobic group, an alkoxylated hydrophilic group and a nonionic or anionic capping group. Examples of suitable hydrophobic groups include nonylphenol, octylphenol and tristyrylphenol. Examples of suitable alkoxylated hydrophilic groups include ethylene oxide, propylene oxide and ethylene oxide/propylene oxide groups. Examples of suitable capping groups include hydroxyl, carboxyl, sulfonyl, phosphonyl, or mixtures thereof. Such residue and scum reducing compounds are included in developer solutions in amounts of from about 0.05% to about 1.0% by weight.

Although the developer solutions disclosed in U.S. 5,922,522; U.S. 6,063,550; and U.S. 6,248,506 B1 provide an effective means of reducing the amount of build-up of residue and scum on substrates containing photoresist, such as circuit boards, and equipment used in the manufacture of electronic components, there is still a need for a composition and method for cleaning or removing built-up residue and scum from various substrates such as developer apparatus. Regardless of the efforts to prevent build-up of residue and scum in developer apparatus such as a conventional spin developer, or a spray developer where developer solution is sprayed onto a substrate surface, repeated use of such apparatus inevitably results in the build-up of residue and scum. At a certain point the residues and scum accumulate to such an extent that the equipment is shut down for cleaning, thus reducing product output. Such residue and scum include hydrophobic aromatic materials such as photoinitiators, dyes, (meth)acrylic monomers and other organic materials that make up photoresists. Such residue and scum are often difficult to emulsify with conventional developer apparatus cleaners.

Conventional cleaners used to remove residue and scum may vary in composition. Typically, such conventional cleaners include as active ingredients a strong base such as sodium hydroxide, and chelating agents such as ethylene diamine tetraacetate (EDTA). Surfactants, solvents and emulsifying agents may also be included in the cleaners. Conventional cleaners are employed at temperature ranges from about 45° C to about 55° C. Such conventional cleaners are primarily used because of the low cost of their ingredients. However, workers in the field using such conventional cleaners have discovered that the residue problem is often made worse. Often the equipment has to be manually cleaned to remove the residue from the photoresist as well as the conventional cleaners. Such manual cleaning is both a labor and time intensive operation that can cause a significant loss of production time. Further, as mentioned above, such cleaners are not effective enough for removing residue from new generation photoresists that have many hydrophobic aromatic materials.

U.S. 6,268,323 B 1 discloses a photoresist stripping and cleaning composition that is allegedly non-corrosive. The composition contains about 5% to 50% by weight of an organic solvent to solubilize the active components of the cleaning composition, about 10% to 90% by weight of an alkonolamine to remove or strip photoresist and plasma etch residue from a substrate, about 0.1% to 10% by weight of a carboxylic acid as a corrosion inhibitor, and about 1% to. 40% by weight of water. The '323 patent alleges that the cleaning compositions are effective in removing a wide variety of organic polymeric materials and plasma-etch residues from substrates such as silicon, silicon dioxide, silicon nitride, polysilicon, aluminum, aluminum alloys, copper, copper alloys, and polyimides. Examples of organic polymeric materials that the '323 patent allegedly cleans are positive-working and negative-working g-line, i-line and deep UV resists, electron beam resists, X-ray resists, ion beam resists, and organic dielectric materials such as polyimide resins. The cleaning composition is applied by spraying the cleaning composition on the substrate to be cleaned, or the substrate may be immersed in the cleaning composition.

While the '323 patent addresses problems associated with stripping polymeric materials and plasma etch residues from the foregoing mentioned substrates, the patent does not address cleaning build-up, hard to emulsify, photoresist residue from substrates such as developer apparatus and other equipment used in manufacturing printed wiring and circuit boards. Additionally, as admitted in the '323 patent, cleaning compositions containing alkanolamines pose serious corrosion problems especially with aluminum substrates. Although the composition of the '323 patent contains carboxylic acids that allegedly inhibit corrosion caused by alkanolamines, a cleaning composition for the removal of organic materials and residues thereof without an alkanolamine is highly desirable to further reduce the chances of corrosion of a substrate.

U.S. 6,231,678 B1 discloses an aqueous cleaning composition composed of at least one short-chain organic acid, or a mixture of two short-chain organic acids. An example of a composition disclosed in the patent is about 2-4% by weight each of citric acid and lactic acid. Another composition disclosed is about 2-4% by weight each of lactic acid and acetic acid. Surfactants are optional in the composition. The patent alleges that the cleaning composition may be employed to delacquer coatings from metal. Such coatings are lacquers, paints, natural and synthetic varnishes. However, the patent does not address stripping or cleaning photoresist or photoresist residue from any substrate, especially difficult to emulsify, build-up photoresist residue from manufacturing apparatus.

U.S. patent application publication 2002/0008725 Al discloses a cleaning composition composed of organic acids, salts of organic acids, or organic acid esters. The cleaning composition is formulated for specifically cleaning "koga" from an ink-jet recording head, an ink-jet recorder and a cartridge of the ink-jet recorder. Koga is burnt ink. The published patent application does not address cleaning type or photoresist or photoresist residue from any type of substrate, let alone hard to emulsify photoresist residue. Accordingly, there is a need for a cleaning composition for removing photoresist residue from a substrate, especially hard to emulsify residue.

### Summary of the Invention

The present invention is directed to a cleaning composition containing a sufficient amount of a non-chelating organic acid in combination with a chelating organic acid to remove organic residues derived from photoresist from a substrate. Cleaning compositions of the present invention also may contain corresponding salts, and esters of the non-chelating and chelating of the organic acids.

Advantageously, cleaning compositions unexpectedly are effective in removing organic residues deposited by both positive-working and negative-working photoresist from a substrate. Such substrates include, but are not limited to, developer apparatus used in applying developer solution to a photoresist as well as other apparatus used in the manufacture of printed wiring boards. Examples of developer apparatus include, but are not limited to, spray developers where developer is sprayed onto a photoresist, or conventional spin developers, immersion developers, or a batch or feed-and-bleed operation apparatus.

Continuous or prolonged use of equipment employed in applying photoresist or that contacts photoresist during the manufacture of photolithographic devices such as printed wiring boards results in the build-up of undesirable residue on the equipment. The built-up residue may block or clog lines or movable parts on the equipment resulting in production shutdown. Additionally, the residue build-up on printed wiring boards causes defects in the boards such as electrical shorts. Although some solutions that are used in equipment, such as developer solutions, may include compounds that reduce the amount of contaminants that build-up on equipment, in time sufficient amounts of residue or scum build-up such that the equipment requires cleaning. Thus compounds used to reduce residue build-up are no longer effective in maintaining efficient product out-put. Cleaning done with conventional cleaners is not always effective because residue and scum contain chemicals that are difficult to re-emulsify with conventional cleaners. Also, conventional cleaners may further contaminate the equipment and manufactured articles.

### Detailed Description of the Invention

The present invention is directed to a cleaning composition containing a non-chelating organic acid in combination with a chelating organic acid. The cleaning compositions of the present invention may be aqueous or organic. A non-chelating organic acid within the scope of the present invention, includes, but is not limited to, a mono-carboxylic acid, a sulfonic acid (-SO₃H), or a phosphonic acid (-PO₃H₂), or salts or esters thereof. A chelating organic acid within the scope of the present invention includes, but is not limited to, an organic acid with one or more hydroxyl groups on the molecular structure. The organic acid may be a mono-carboxylic acid, a dicarboxylic acid, a tricarboxylic acid, a tetracarboxylic acid, or salts or esters thereof. Chelating organic acids of the present invention also include, but are not limited to, acids with one or more hydroxyl groups containing one or more sulfonic acid groups (-SO₃H) or phosphonic acid groups (-PO₃H₂). Both the non-chelating acids and chelating acids as well as their salts and esters may be aliphatic, cycloaliphatic or aromatic.

Examples of suitable non-chelating acids include formic acid, acetic acid, propionic acid, butyric acid, valeric acid, benzoic acid, isobutyric acid, isovaleric acid, pivalic acid, caproic acid, or phenol or mixtures thereof. Examples of suitable organosulfonic acids include methane sulfonic acid, ethane sulfonic acid, benzene sulfonic acid, and dodecylbenzene sulfonic acid or mixtures thereof.

Examples of suitable chelating acids include lactic acid, citric acid, tartaric acid, glycolic acid, glyceric acid, oxalic acid, malonic acid, succinic acid, glutaric acid, adipic acid, maleic acid, fumaric acid, phthalic acid, isophthalic acid, terephthalic acid, methylmalonic acid, dimethylmalonic acid, citramalic acid, oxalacetic acid, acetoacetic acid, salicylic acid, pyruvic acid, α-ketoglutamic acid, or ethylenediaminetetraacetic acid or mixtures thereof. Examples of suitable organo-polysulfonic acids include benzene disulfonic acid such as benzene-1,3-disulfonic acid and naphthalene di- and polysulfonic acid, or mixtures thereof.

The term "chelating acid" within the scope of the present invention means that the acid may form coordinate links with another compound or ion. While not being bound by a particular theory, workers in the art believe that the hydroxy and carboxy groups, for example, of a chelating acid act as ligands to form a bidentate or tridentate bond with another compound or ion.

A preferred active acid cleaning component of the present invention is a non-hydroxyorganic acid in combination with a hydroxyorganic acid. An example of such a combination is lactic acid in combination with acetic acid. Such compositions are not only effective in removing residue and scum from equipment parts, but such compositions are compatible with the parts such that they do not cause corrosion. Also, the combination of a hydroxyorganic acid and a non-hydroxyorganic acid has a higher flash point than many other acid combinations. Accordingly, such acid combinations may be employed at higher cleaning temperatures than acid combinations of lower flash points without concern of hazards to workers. Also, the advantage of cleaning at higher temperatures may be employed to assist in scum and residue removal.

The proportion of each type of acid, i.e., chelating and non-chelating acid, may be from 10% by weight of one type of acid to 90% by weight of the other type of acid for the total acid content of the cleaning composition. Preferably, the weight ratio of one acid to the other is from 20% by weight to 80% by weight. More preferably, the weight ratio of one acid to the other acid is from 35% by weight to 65% by weight. Most preferably, the weight ratio of each acid is 50% by weight of the acid component of the cleaning composition. Cleaning compositions of the present invention may contain 100% acids, or may contain a solvent and/or adjuvants as discussed below to bring the cleaning composition to 100% by weight.

Solvents employed in the present invention include water or any suitable organic solvent. A suitable solvent within the scope of the present invention is a solvent that solubilizes the components of the cleaning composition, or at least suspends them in solution such that cleaning is effective. Examples of suitable organic solvents include alcohols, glycols, glycol ethers, glycol ether acetates, ketones, esters, aldehydes and the like. Examples of suitable alcohols include, but are not limited to, methanol, ethanol, and isopropyl. Examples of other suitable organic solvents include, but are not limited to, ethylene glycol, diethylene glycol, triethylene glycol, polyethylene glycol, propylene glycol, dipropylene glycol, tripropylene glycol, polypropylene glycol, (C₁-C₄) glycol ethers such as diethylene glycol monomethyl ether, diethylene glycol monopropyl ether, diethylene glycol monobutyl ether, ethylene glycol monomethyl ether, ethylene glycol monopropyl ether, ethylene glycol monobutyl ether, ethylene glycol phenyl ether, dipropylene glycol monomethyl ether, dipropylene glycol monopropyl ether and dipropylene glycol monobutyl ether, (C₁-C₄) glycol ether acetates such as dipropylene glycol monomethyl acetate and propylene glycol monomethyl ether acetate, propylene glycol phenyl ether, (C₁-C₁₂) alkyl acetates such as ethyl acetate, amyl acetate, butyl acetate, propyl acetate, ethyl lactate, ethyl butyrate, acetone, hexanone, pentanone, glyoxal, tetrahydrofuran or mixtures thereof.

In another embodiment of the present invention, cleaning compositions of the present invention may contain adjuvants to assist the non-chelating and chelating acid cleaning component. Such adjuvants include, but are not limited to, surfactants and antifoam agents. Examples of such surfactants include, but are not limited to, quaternary ammonium salts, water soluble or water dispersable polymers, or surfactants having the following general formula: 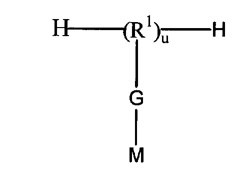 where R¹ is a (C₁ to C₆) alky or (C₆ to C₁₄) aryl group, G is a carboxyl, sulfonyl, or phosphonyl, M is a charge-balancing cation such as sodium, potassium, or ammonium, and u is an integer of from 1 to 200, preferably an integer of from 2 to 200. When u is an integer of 2 or greater, G may be the same or different. An example of such surfactants is Newkalgen® TX-C (obtainable from Takemoto Oil and Fat Co.) which is a phenolic sulfonyl salt. Other suitable secondary surfactants include, but are not limited to, alcohol alkoxylates, amine alkoxylates, fatty alcohol alkoxylates, fatty sorbitan esters and their alkoxylates, amphoteric surfactants, and the like. Examples of two commercially available surfactants are the ethylene oxide and propylene oxide surfactants Pluronic® and Tetronic® (obtainable from BASF).

Antifoam agents that may be employed include, but are not limited to, such agents as Morton 2750 Antifoam® and Antifoam® 80 both obtainable from Morton International.

When adjuvants are included in the cleaning compositions of the present invention, they are included in amounts of from 1% to 30% by weight of the cleaning composition, preferably from 5% to 10% by weight of the cleaning composition. When adjuvants are employed, the active acid cleaning component composes from 5% to 70% by weight of the cleaning composition. A solvent may be employed to bring the composition to 100% by weight. Preferably, the active acid cleaning component composes from 10% to 60% by weight of the cleaning composition with the remainder of the composition a solvent, when a solvent is employed.

Advantageously, cleaning compositions of the present invention remove built-up organic residue and scum from a substrate by contacting the built-up residue and scum with a sufficient amount of a cleaning composition such that the built-up residue and scum are solubilized by the cleaning composition. Agitation also may be employed if needed to help loosen residue and scum from a substrate.

Optionally, after cleaning a substrate of built-up residue and scum with the cleaning composition of the present invention, the substrate may be rinsed with water to remove loosened residue and scum remaining on the substrate. The cleaning composition and method of the present invention may remove from 85% by weight to 98% by weight of built-up residue and scum from a substrate.

Surprisingly, the cleaning compositions of the present invention remove built-up organic residue and built-up organic scum from both positive-working (both liquid and dry film) and negative-working photoresist (both liquid and dry film). Such built-up organic residue and organic scum on a substrate are difficult to remove with conventional cleaners and surfactants because of the types of chemicals used in photoresists, in particular the new generation of photoresists which contain many compounds of a hydrophobic aromatic character.

Additionally, the cleaning compositions of the present invention also remove built-up residues deposited by secondary photoresists from a substrate. Such photoresist may be employed in soldermasks. Residue and scum are deposited on a substate as a result of component separation in the soldermask. Such component separation may be exacerbated when an improperly balanced soldermask developer solution, i.e. improper developing conditions and/or soldermask developer solution chemistry, contact the soldermask. Residue and scum build-up on such substrates as printed wiring boards and soldermask developer apparatus. Cleaning compositions of the present invention are especially suitable for removing built-up residue the may appear as a peach to yellow solid on apparatus surfaces. The peach to yellow solid is composed predominantly of photoinitiators, some monomers and dye from the photoresist. Much of the photoinitiator material is aromatic and hydrophobic, thus making removal difficult with many conventional cleaners. Generally, there is a higher level of hydrophobic aromatic compounds in secondary photoresist formulations than primary photoresist formulations. Thus, cleaning residue and scum deposited by secondary photoresists is a further improvement and advantage over conventional cleaners.

Residues and scum from photoresist include, but are not limited to, such chemical materials as hydrophobic aromatic materials such as photoinitiators, thermoinitiators, dyes, acrylic, and methacrylic monomers. Photoinitiators such as photoacid generators, photobase generators or free-radical generators once built-up as residue or scum on a substrate are more difficult to remove than many of the other components that compose the residue and scum. Such materials do not readily re-emulsify once they build-up on a substrate such as photolithographic manufacturing apparatus.

Photoresists vary in composition. Generally, a photoresist composition may compose from 20% to 90% by weight of a binder polymer, 15% to 50% by weight of α,β-ethylenically unsaturated compounds (cross-linkers) such as monomers and short-chain oligomers and from 0.1% to 25% by weight of a photoinitiator or photoinitiator chemical system. Liquid photoresists may contain a larger concentration of binder in relation to monomers or short-chain oligomers whereas dry film may contain larger concentrations of monomers or short-chain oligomers. Such concentrations are known in the art. Other components employed in a photoresist that may contribute to residue and scum build-up are discussed below. Built-up residue and scum from liquid photoresist appears as crystalline material on a substrate.

Examples of components that compose a photoresist that may cause undesirable built-up residue or scum on a substrate include, but are not limited to, polymeric binders such as those containing as polymerized units one or more ethylenically or acetylenically unsaturated monomers. Examples of monomers include, but are not limited to: (meth)acrylic acid, (meth)acrylamides, alkyl (meth)acrylates, alkenyl (meth)acrylates, aromatic (meth)acrylates, vinyl aromatic monomers, nitrogen-containing compounds and their thio-analogs, substituted ethylene monomers, cyclic olefins, substituted cyclic olefins, and the like. Preferred monomers include (meth)acrylic acid, alkyl (meth)acrylates and vinyl aromatic monomers. Such polymeric binders may be homopolymers or copolymers and preferably copolymers.

Cross-linkers that may cause residue or scum build-up include di-, tri-, tetra-, or higher multi-functional ethylenically unsaturated monomers. Examples of such cross-linkers include, but are not limited to: trivinylbenzene, divinyltoluene, divinylpyridine, divinylnaphthalene and divinylxylene; and such as ethyleneglycol diacrylate, trimethylolpropane triacrylate ("TMPTA"), diethyleneglycol divinyl ether, trivinylcyclohexane, allyl methacrylate ("ALMA"), ethyleneglycol dimethacrylate ("EGDMA"), diethyleneglycol dimethacrylate ("DEGDMA"), propyleneglycol dimethacrylate, propyleneglycol diacrylate, trimethylolpropane trimethacrylate ("TMPTMA"), divinyl benzene ("DVB"), glycidyl methacrylate, 2,2-dimethylpropane 1,3 diacrylate, 1,3-butylene glycol diacrylate, 1,3-butylene glycol dimethacrylate, 1,4-butanediol diacrylate, diethylene glycol diacrylate, diethylene glycol dimethacrylate, 1,6-hexanediol diacrylate, 1,6-hexanediol dimethacrylate, tripropylene glycol diacrylate, triethylene glycol dimethacrylate, tetraethylene glycol diacrylate, polyethylene glycol 200 diacrylate, tetraethylene glycol dimethacrylate, polyethylene glycol dimethacrylate, ethoxylated bisphenol A diacrylate, ethoxylated bisphenol A dimethacrylate, polyethylene glycol 600 dimethacrylate, poly(butanediol) diacrylate, pentaerythritol triacrylate, trimethylolpropane triethoxy triacrylate, glyceryl propoxy triacrylate, pentaerythritol tetraacrylate, pentaerythritol tetramethacrylate, dipentaerythritol monohydroxypentaacrylate, ethoxylated diacrylates, ethoxylated triacrylates such as ethoxylated TMPTA and ethoxylated TMPTMA, ethoxylated tetraacrylates, divinyl silane, trivinyl silane, dimethyl divinyl silane, divinyl methyl silane, methyl trivinyl silane, diphenyl divinyl silane, divinyl phenyl silane, trivinyl phenyl silane, divinyl methyl phenyl silane, tetravinyl silane, dimethyl vinyl disiloxane, poly(methyl vinyl siloxane), poly(vinyl hydro siloxane), poly (phenyl vinyl siloxane), glycosyl ureas including di-, tri- and tetra-glycosyl ureas, epoxies and mixtures thereof. Such cross-linking agents are generally commercially available.

Photoimageable compositions contain one or more photoactive components. The photoactive components may be photoacid generators, photobase generators or free-radical generators. Such photoactive components are a major source of scum formations.

Example of photoacid generators include halogenated triazines, onium salts, sulfonated esters, halogenated sulfonyloxy dicarboximides, diazodisulfones, α-cyanooxyaminesulfonates, imidesulfonates, ketodiazosulfones, sulfonyldiazoesters, 1,2-di(arylsulfonyl)hydrazines and the like.

Free-radical generators include, but are not limited to, n-phenylglycine, aromatic ketones such as benzophenone, N, N'-tetramethyl-4, 4'-diaminobenzophenone [Michler's ketone], N,N'-tetraethyl-4,4'-diaminobenzophenone, 4-methoxy-4'-dimethylaminobenzophenone, 3,3'-dimethyl-4-methoxybenzophenone, p,p'-bis(dimethylamino)benzophenone, p,p'-bis(diethylamino)-benzophenone, anthraquinone, 2-ethylanthraquinone, naphthaquinone and phenanthraquinone, benzoins such as benzoin, benzoinmethylether, benzoinethylether, benzoinisopropylether, benzoin-n-butylether, benzoin-phenylether, methylbenzoin and ethybenzoin, benzyl derivatives such as dibenzyl, benzyldiphenyldisulfide and benzyldimethylketal, acridine derivatives such as 9-phenylacridine and 1,7-bis(9-acridinyl)heptane, thioxanthones such as 2-chlorothioxanthone, 2-methylthioxanthone, 2,4-diethylthioxanthone, 2,4-dimethylthioxanthone and 2-isopropylthioxanthone, acetophenones such as 1,1-dichloroacetophenone, p-t-butyldichloro-acetophenone, 2,2-diethoxyacetophenone, 2,2-dimethoxy-2-phenylacetophenone, and 2,2-dichloro-4-phenoxyacetophenone, 2,4,5-triarylimidazole dimers such as 2-(o-chlorophenyl)-4,5-diphenylimidazole dimer, 2-(o-chlorophenyl)-4,5-di(m-methoxyphenyl imidazole dimer, 2-(o-fluorophenyl)-4,5-diphenylimidazole dimer, 2-(o-methoxyphenyl)-4,5-diphenylimidazole dimer, 2-(p-methoxyphenyl)-4,5-diphenylimidazole dimer, 2,4-di(p-methoxyphenyl)-5-phenylimidazole dimer, 2-(2,4-dimethoxyphenyl)-4,5-diphenylimidazole dimer and 2-(p-methylmercaptophenyl)-4,5-diphenylimidazole dimer, and the like. Though, not a free-radical generator, triphenylphosphine may be included in the photoactive chemical system as a catalyst.

Optional additives that may be used in photoimageable compositions and that cause residue and scum include, but are not limited to: anti-striation agents, plasticizers, speed enhancers, fillers, dyes, film forming agents, non-polymerizable organic acids and the like. Suitable plasticizers include esters such as dibenzoate esters. Non-polymerizable organic acids may also be added to photoresist compositions. Such organic acids are substantially non-polymerizable with the polymeric binders, optional cross-linking agents or both. A wide variety of organic acids may suitably be added to photoresist compositions. Suitable organic acids include, but are not limited to, alkanecarboxylic acids and arylcarboxylic acids, sulfonic acids such as alkanesulfonic acids and arylsulfonic acids, phosphonic acids such as alkylphosphonic acids and arylphosphonic acids, and the like. Exemplary carboxylic acids include, but are not limited to, (C₁-C₁₂)alkylcarboxylic acids, (C₁-C₁₂)alkyldicarboxylic acids, (C₁-C₁₂)alkyltricarboxylic acids, substituted (C₁-C₁₂)alkylcarboxylic acids, substituted (C₁-C₁₂)alkyldicarboxylic acids, substituted (C₁-C₁₂)alkyltricarboxylic acids, amine carboxylic acids such as ethylenediamine tetraacetic acid, arylcarboxylic acids such as arylmonocarboxylic acids, aryldicarboxylic acids and aryltricarboxylic acids, and substituted arylcarboxylic acids. Preferred organic acids include formic acid, acetic acid, propionic acid, oxalic acid, malonic acid, succinic acid, glutaric acid, adipic acid, glycolic acid, lactic acid, tartaric acid, citric acid or malic acid, ethylenediamine tetraacetic acid, phthalic acid, benzene tricarboxylic acid, salicilic acid, cyclohexanecarboxylic acid, 1,4-cyclohexanedicarboxylic acid and sebacic acid.

A wide variety of photoresist strip enhancers also may be used in photoresists. Such strip enhancers may contribute to residue and scum build-up. Examples of photoresist strip enhancers are compounds containing one or more trihalomethyl-substituents in an alpha position relative to a group capable of stabilizing a negative charge.

In one embodiment a cleaning composition of the present invention may be used to clean residue and scum of photoresist built-up on a developer apparatus. Such apparatus are well known in the electronics industry. Developer apparatus are employed to apply a composition of developer solution and photoresist to a substrate such as a printed wiring board. Developer solutions contain bases such as sodium carbonate or potassium carbonate, an antifoam agent and water. Additionally, developer solutions may contain compounds intended to prevent or inhibit the formation of residue and scum from photoresist. Examples of such residue reducing agents are disclosed in U.S. 6,248,506 B1, U.S. 6,063,550, and U.S. 5,922,522. Although such residue reducing compounds are effective in reducing the amount of residue and scum build-up, repeated and continuous use of developer apparatus still leads to build-up of difficult to remove residue and scum. After repeated and continuous use for 200 hours to 400 hours or more, the developer apparatus is cleaned to remove the built-up residue and scum.

Cleaning involves filling the developer apparatus with a sufficient amount of a cleaning composition to remove the built-up residue and scum. Suitable concentrations of components that compose the cleaning compositions to remove built-up residue and scum are described above. Alternatively, the cleaning composition may be mixed with developer solution in the developer apparatus. A sufficient amount of developer solution is removed from the developer apparatus such that the cleaning composition composes from 10% by volume to 100% by volume of the now formed cleaning bath. Preferably, the cleaning composition composes from 25% by volume to 45% by volume of the cleaning bath. The cleaning bath is circulated through the developer apparatus for a sufficient amount of time to remove built-up residue and scum, preferably for 60 minutes to 4 hours. Advantageously, the cleaning compositions of the present invention may be employed to clean residue and scum from a substrate at temperatures of from 20° C to 70° C. Preferably, cleaning is performed at a temperature range of from 35° C to 55° C.

Optionally, the developer apparatus may be rinsed with water after the cleaning bath is drained from the developer apparatus to remove any loose residue and scum that did not drain from the apparatus with the cleaning bath. The developer apparatus is determined sufficiently cleaned when the water rinse is transparent to the naked eye. An insufficiently cleaned apparatus has turbid rinse water.

Advantageously, the cleaning composition and method of the present invention provides for a method of removing built-up organic residue and organic scum from a substrate. The cleaning composition is highly effective for removing built-up organic residue and organic scum of photoresist from a substrate such as equipment used in manufacturing printed wiring boards. The cleaning composition and method may remove from 85% up to 98% by weight of undesirable built-up organic residue and scum from a substrate. The cleaning composition and method of the present invention eliminates the use of conventional cleaners that may further aggravate contamination of equipment and printed wiring boards.

While the present invention is described in the context of cleaning organic residue and scum in the electronics industry, the cleaning compositions of the present invention may be employed to clean organic residue and organic scum from any substrate.

The following example is intended to further illustrate the present invention but is not intended to limit the scope of the invention.

### Example

### Dissolution of Photoresist Residue

The photoresist was composed of 50% by weight of a binder composed of an acrylic polymer; 37% by weight of an acrylic monomer; 10% by weight of a photoinitiator package with hexaarybiimidazole as one type of photoinitiator; and the remainder of the composition was composed of dyes, stabilizers and flow agents in conventional amounts. The residue deposited by the photoresist on developer equipment parts was collected for solubility testing. Such equipment parts were composed of materials disclosed in Table 2 below.

About 0.1 g of photoresist residue was added to 100 mL of each cleaning solution under evaluation. Nine cleaning solutions were tested as shown in Table 1 below. A stir bar was added to each mixture and spun at 100 RPM. The temperature remained constant at a chosen value. Samples were tested at ambient temperature which was 21°C (70°F) and at a temperature of 49°C (120°F). The mixture was monitored every 15 minutes to determine the length of time required to completely dissolve the residue. The testing was stopped in certain cases marked with an asterisk (*) because the residue had not completely dissolved after an extended amount of time (7 hours). Acceptable cleaning times in the industry are in the one to three hour range. Longer cleaning times are not as acceptable because time is taken away from the production of printed wiring boards. The photoresist residue under study was rich in hydrophobic and aromatic components. Cleaning compositions composed of only acetic acid or lactic acid, and acid and water acted as controls.

**Table 1:**

| **Residue Dissolution Times at 21°C and 49°C** | | | |
|---|---|---|---|
| **Cleaning Composition** | **Concentration (Wt.%)** | **Residue Dissolution Time (hr.) at 21°C (70°F)** | **Residue Dissolution Time (hr.) at 49°C (120°F)** |
| **acetic acid (glacial)** | 100 | ***0.5*** | X (flash point = 43-45°C) |
| **acetic acid/water** | 50/50 | >7* | 4 |
| **acetic acid/water** | 25/75 | >7* | >7* |
| | | | |
| **lactic acid (88% in water)** | 100 | >7* | >7* |
| | | | |
| **lactic acid/acetic acid** | 50/50 | ***1.5*** | ***1.5*** |
| **lactic acid/acetic acid** | 62.5/37.5 | 4.25 | ***1.5*** |
| **lactic acid/acetic acid** | 75/25 | 5.5 | ***2*** |
| **lactic acid/acetic acid** | 97.5/12.5 | >7* | 3.5 |
| **lactic acid/acetic acid** | 93.75/6.25 | >7* | 4 |

| | | | |
|---|---|---|---|
| * = test stopped after 7 hours; acceptable cleaning times are in bold. | | | |

Equipment Parts Compatibility Testing: Various types of materials as shown in Table 2 that comprise equipment parts that were cleaned were soaked for 3 hours at 21°C (70°F). Three cleaning solutions were employed as shown in Table 2 below. Compatibility of the parts with the cleaning compositions was determined via the following tests:
- Percent Weight Change: to determine whether the part was swelling or dissolving (>5% considered a failure).
- Visual and Tactile Examination: to determine whether the physical properties (e.g. appearance, hardness, or elongation) of the part were changing compared to a control part that was not soaked.
- Water Rinsing: to determine whether the cleaning compositions can be cleaned off the parts with water, a standard rinsing chemical, without leaving an obvious residue.

The results are as follows in Table 2.

**Table 2:**

| **Percent Weight Change After Soaking at 21°C (70°F) for 3 Hours** | | | |
|---|---|---|---|
| **Substrate Cleaned** | **% Weight Change in Acetic Acid (glacial)** | **% Weight Change in Lactic Acid (88% in water)** | **% Weight Change in Lactic Acid/Acetic Acid = 50/50** |
| **Polyvinylchloride** | +0.1 | -0.2 | +0.1 |
| **Polypropylene** | -0.1 | +0.2 | +0.1 |
| **Tygon®** | +3.3 | 0 | +0.1 |
| **Silicone Rubber** | +6.0 | +0.4 | +2.4 |
| **Nitrile Rubber** | +16.2 | +0.2 | +2.6 |
| **Buna-N Rubber** | +23.5 | +2.0 | +2.8 |
| **Viton®** | +45.5 | +0.8 | +1.0 |
| **EPDM Rubber** | +1.5 | +0.1 | +0.7 |
| **Neoprene Rubber** | +6.0 | +0.4 | +3.6 |
| **304 Stainless Steel** | 0 | 0 | 0 |
| 316 Stainless Steel | 0 | 0 | 0 |
| **Titanium** | 0 | 0 | 0 |

**Visual and Tactile Examination:** Other than the swelling (see weight change measurements above), there were no other obvious changes observed from visual and tactile examinations of the parts.
**Water Rinsing:** All of the example cleaning compositions rinsed off the parts cleanly with water.

Glacial acetic acid dissolved the residue in a short amount of time. Glacial acetic acid, however, was very aggressive towards equipment parts as seen in the weight change data above. Failures (>5% weight change) are noted for the silicone rubber, nitrile rubber, buna-N rubber, Viton®, and neoprene rubber when soaked in glacial acetic acid. Dilution of the acetic acid in water to minimize swelling of parts resulted in poor dissolution of residue even when elevated temperatures (49°C) were utilized.

A solution of 88% lactic acid in water was ineffective in dissolving the photoresist residue within 3 hours as shown in Table 1. Acceptable cleaning times in the printed wiring board industry are 3 hours or less. Longer cleaning times are not acceptable because time is taken away from the production of boards. The lactic acid solution, however, did not fail the equipment part compatibility testing as shown in Table 2.

When the lactic acid (88%) and acetic acid (glacial) were combined, the mixture dissolved the photoresist residue at ambient (21°C) and elevated (49°C) temperatures under 7 hours except for lactic acid/acetic acid mixtures of 97.5/12.5 and 93.75/6.75 at 21°C. Best results were obtained with a lactic acid/acetic acid mixture of 50/50. In addition, the 50/50 mixture of lactic acid and acetic acid was compatible with all the equipment parts under study. In some cases (i.e. Tygon®, nitrile rubber, buna-N rubber, and Viton®), the dramatic improvement in material compatibility was beyond being an average effect between the individual lactic acid and acetic acid effects. Thus the combination of an organic acid and organic hydroxy acid demonstrated an improvement in cleaning for both the dissolution of the resist residue and equipment parts compatibility. An added benefit of this particular mixed system was that glacial acetic acid has a flash point of 43-45°C (109-112°F) whereas the flash point of the glacial acetic acid/88% lactic acid mixture at a weight percent ratio of 50/50 is 57-60°C (134-140°F). Thus the mixture was a considerably safer product to handle. While the lactic acid/acetic acid mixture may be safely employed at elevated temperatures, workers try to clean at ambient temperatures since elevated temperatures may be more detrimental to equipment parts. Another added benefit was the lower freezing point for the mixture, <9°C (<48°F), when compared to the freezing point for glacial acetic acid, 17°C (62°F). This fact significantly relaxes the restrictions on product storage.

The key features of the cleaning composition were:
- Rapid and effective dissolution of photoresist residues
- Low use temperature
- Minimal effect on equipment parts
- Safer
- Easier to store

## Claims

1. A cleaning composition comprising an active cleaning component consisting of a first component consisting of a non-chelating organic acid, a salt of a non-chelating organic acid, an ester of a non-chelating organic acid and mixtures thereof in combination with a second component consisting of a chelating organic acid, a salt of a chelating organic acid, an ester of a chelating organic acid and mixtures thereof; the active cleaning component is in a sufficient amount to remove photoresist scum and residue from a substrate.

2. The cleaning composition of claim 1, wherein the first component comprises formic aid, acetic acid, propionic acid, butyric acid, valeric acid, benzoic acid, isobutyric acid, isovaleric acid, pivalic acid, caproic acid, phenol, an organosulfonic acid, or mixtures thereof.

3. The cleaning composition of claim 1, wherein the second component comprises lactic acid, citric acid, tartaric acid, glycolic acid, glyceric acid, oxalic acid, malonic acid, succinic acid, glutaric acid, adipic acid, maleic acid, fumaric acid, phthalic acid, isophthalic acid, terephthalic acid, methylmalonic acid, dimethylmalonic acid, citramalic acid, oxalacetic acid, acetoacetic acid, salicylic acid, pyruvic acid, α-ketoglutamic acid, an organo-polysulfonic acid, or ethylenediaminetetraacetic acid or mixtures thereof.

4. The cleaning composition of claim 1, wherein the active cleaning component consists of acetic acid and lactic acid.

5. The cleaning composition of claim 4, wherein a weight proportion of lactic acid ranges from 10% to 90% and acetic acid ranges from 90% to 10% by weight of the active acid cleaning component of the composition.

6. The cleaning composition of claim 1, further comprising an adjuvant.

7. A cleaning composition consisting of a first acid component and a second acid component, the first acid component consists of acetic acid, propionic acid, butyric acid, valeric acid, benzoic acid, isobutyric acid, isovaleric acid, pivalic acid, caproic acid, phenol and mixtures thereof; the second acid component consists of lactic acid, citric acid, tartaric acid, glycolic acid, glyceric acid, oxalic acid, malonic acid, succinic acid, glutaric acid, adipic acid, maleic acid, fumaric acid, phthalic acid, isophthalic acid, terephthalic acid, methylmalonic acid, dimethylmalonic acid, citramalic acid, oxalacetic acid, acetoacetic acid, salicylic acid, pyruvic acid, α-ketoglutamic acid, or ethylenediaminetetraacetic acid and mixtures thereof

8. A method of cleaning a substrate comprising contacting a contaminated substrate with a cleaning composition to clean the contaminated substrate, the cleaning composition comprises an active cleaning component consisting of a first component in combination with a second component, the first component consists of a non-chelating organic acid, a salt of a non-chelating organic acid, an ester of a non-chelating organic acid and mixtures thereof, the second component consists of a chelating organic acid, a salt of a chelating organic acid, an ester of a chelating organic acid and mixtures thereof, the active cleaning component is included in the cleaning composition in a sufficient amount to remove scum and residue from the contaminated substrate.

9. The method of claim 8, wherein the cleaning composition further comprises an adjuvant.

10. The method of claim 8, wherein the cleaning temperature ranges from about 20°C to about 70°C.
